# EUROPEAN PATENT APPLICATION

(11) **EP 2 149 704 A1**
(43) Date of publication of application: **03.02.2010**
(21) Application number: 08752297.5
(22) Date of filing: 01.05.2008
(51) Int. Cl.: F03G 7/06, B81B 3/00, C22C 14/00, C23C 14/14, C23C 14/34

(54) **TWO-DIRECTION SHAPE-MEMORY ALLOY THIN FILM ACTUATOR AND METHOD FOR MANUFACTURING SHAPE-MEMORY ALLOY THIN FILM USED IN THE ACTUATOR**

(30) Priority: 11.05.2007 JP 2007126330; 27.06.2007 JP 2007169236
(71) Applicant: National Institute for Materials Science, Tsukuba-shi, Ibaraki 305-0047 (JP)
(72) Inventor: ISHIDA, Akira, Tsukuba-shi Ibaraki 305-0047 (JP); SATO, Morio, Tsukuba-shi Ibaraki 305-0047 (JP)
(74) Representative: Hall, Matthew Benjamin
(86) International application number: PCT/JP2008/058392
(87) International publication number: WO 2008/142980

(57) **Abstract**

A bidirectional shape memory alloy thin film actuator includes a crystalline shape memory alloy thin film, and is formed substantially in a single layer while having a residual stress during deposition, and operates at a temperature equal to or higher than room temperature, and is not required to be applied with a particular bias force.

## Description

### TECHNICAL FIELD

The present invention relates to a bidirectional shape memory alloy thin film actuator, and a method for manufacturing a shape memory alloy thin film used therefor.

### BACKGROUND ART

With a general shape memory alloy thin film, it is only the high temperature phase to memorize the shape. Accordingly, when a reversible shape change (bidirectional shape change) is required as with an actuator, an external stress (bias force) for deforming the low temperature phase is necessary. As the methods for applying a bias force, there is a method in which a thermal stress from a substrate due to cooling after a high temperature heat treatment at 500°C or more is applied; a method in which a spring force or a hydrostatic pressure is externally applied; or other methods. However, all the methods unfavorably require a heat treatment at high temperatures, or a complicated structure.

Regarding the method for obtaining a bidirectional shape memory alloy thin film actuator by a low temperature process, it has been reported that, a crystalline Ti-rich side Ti-Ni-Cu alloy thin film (Ti_{51.7}Ni_{34.8}Cu_{14.2}) is formed on a Si substrate heated to 250°C to 385°C, which can result in a bidirectional shape memory alloy thin film actuator by the thermal stress from the Si substrate (Non-Patent Document 1). As for the method for obtaining a crystalline thin film of Ti-Ni binary alloy, there is known a method in which a metal or alloy substrate having a melting point of 1000°C or more is heated to 250°C to 550°C (Patent Document 1). However, as shown in FIG 6 of Patent Document 1, a thin film having a transformation temperature equal to or higher than room temperature cannot be obtained, and bidirectional property is also not shown.

Whereas, a Ni-rich side Ti-Ni alloy has a lower transformation temperature than that of a Ti-rich side Ti-Ni alloy (Non-Patent Document 2). Even when a crystalline Ti-Ni thin film (TJ₄₉.₂NJ₃₀.₈) is obtained by heating the substrate to 320°C, the thin film is required to be cooled by liquid nitrogen for use because of the lower transformation temperature than room temperature, and only a unidirectional shape memory effect is shown. This requires a bias force (Non-Patent Document 3).

Further, as a method for manufacturing a Ti-Ni-Cu alloy thin film with a (Ni, Cu)-rich side composition, having a transformation temperature equal to or higher than room temperature, there is known a method for manufacturing a Ti-Ni-Cu ternary shape memory alloy in which an amorphous Ti-Ni-Cu alloy having a Ti content of 44 to 49 at%, a Cu content of 20 to 30 at%, and the balance including inevitable elements and Ni is heated at 500 to 700°C for not more than 100 hours for crystallization (Patent Document 2). However, this method thus has a defect of requiring a heat treatment at high temperatures.
Patent Document 1: JP-A-2000-54122
Patent Document 2: JP-A-2005-172939
Non-Patent Document 1: Constrained martensitic transformations in TiNiCu films, Corneliu M. Craclunescu, Jian Li, Manfred Wuttig, Thin Solid Films 434 (2003) 271-275
Non-Patent Document 2: STUDY AND FUTURE PROSPECTS OF SHAPE MEMORY ALLOY THIN FILM, AKIRA ISHIDA, MATERIA 40 (2001) 44-51
Non-Patent Document 3: Structure and thermal stability in titanium-nickel thin films sputtered at elevated-temperature on inorganic and polymeric substrate, Li Hou, T.J. Pence, and David S. Grummon, Mat. Res. Soc. Symp. Proc. 360 (1995) 369-374

### DISCLOSURE OF INVENTION

### Problems that the Invention is to Solve

In view of the foregoing circumstances, it is an object of the present invention to implement a bidirectional shape memory alloy thin film actuator which operates at a temperature equal to or higher than room temperature, and is not particularly required to be applied with a bias force, and further, to manufacture the same with simplicity.

### Means for Solving the Problems

A bidirectional shape memory alloy thin film actuator of an invention 1 is a bidirectional shape memory alloy thin film actuator including a crystalline shape memory alloy thin film, characterized by being substantially formed in a single layer while still having a residual stress during deposition.

An invention 2 is a method for manufacturing the bidirectional shape memory alloy thin film actuator according to the invention 1, characterized by: depositing a crystalline shape memory alloy thin film on a substrate while heating the substrate to less than the heat resistant temperature, and then, removing the substrate from the thin film, resulting in a single layer.

A bidirectional shape memory alloy thin film actuator of an invention 3 is a bidirectional shape memory alloy thin film actuator including a substrate and a shape memory alloy thin film integral therewith, **characterized in that** the substrate is plastically deformable in a variant rearrangement deformation region of the thin film, and the substrate is plastically deformed, and is set in an initial shape.

A bidirectional shape memory alloy thin film actuator of an invention 4 is a bidirectional shape memory alloy thin film actuator including a substrate and a shape memory alloy thin film integral therewith, and showing a transformation temperature equal to or higher than room temperature, **characterized in that** the substrate is bendable metal foil or resin film.

An invention 5 is the bidirectional shape memory alloy thin film actuator according to the invention 1, 3, or 4, **characterized in that** the thin film is a Ti-Ni-Cu shape memory alloy thin film.

An invention 6 is a method for manufacturing a shape memory alloy thin film for use in the bidirectional shape memory alloy thin film actuator of the invention 5, characterized by depositing Ti, Ni, and Cu on a substrate while heating the substrate to 270°C or more and less than the heat resistant temperature thereof, and forming a Ti-Ni-Cu alloy thin film.

An invention 7 is the method for manufacturing a shape memory alloy thin film of the invention 6, **characterized in that** Ti, Ni, and Cu are deposited such that the contents on an atom basis of respective atoms of the deposited Ti-Ni-Cu alloy thin film are Ti: more than 1/2 and less than 2/3 of the total amount, Cu: 14 to 19 % of the total amount, and the balance being Ni.

An invention 8 is the method for manufacturing a shape memory alloy thin film of the invention 6, **characterized in that** Ti, Ni, and Cu are deposited such that the contents on an atom basis of respective atoms of the deposited Ti-Ni-Cu alloy thin film are Ti: more than 1/3 and less than 1/2 of the total amount, Cu: 6 to 26 % of the total amount, and the balance being Ni.

### Advantage of the Invention

In accordance with the invention 1, there is implemented an actuator which does not require an external bias force, and operates by only a shape memory alloy thin film. In accordance with the invention 2, it is possible to manufacture a bidirectional shape memory alloy thin film actuator with ease.

With the shape memory alloy thin film actuator of the invention 3, the initial shape thereof can be set with the shape memory alloy thin film and the substrate integrated. Therefore, the initial shape including the mechanical characteristics of both the substrate and the thin film added therein can be obtained in one processing. For this reason, it is possible to implement a high-precision initial shape with ease.

With the shape memory alloy thin film actuator of the invention 4, it is possible to manufacture a bidirectional shape memory alloy thin film actuator including a substrate applied with deformation and freely disposed in three dimensions.

In accordance with the invention 6, it is possible to efficiently manufacture the shape memory alloy thin film in the bidirectional shape memory alloy thin film actuator of the invention 1, 3, or 4.

In accordance with the invention 7, it is possible to manufacture the actuator which operates at room temperature by heating in the bidirectional shape memory alloy thin film actuator of the invention 1, 3, or 4.

In accordance with the invention 8, it is possible to manufacture a (Ni, Cu)-rich side Ti-Ni-Cu shape memory alloy thin film having a transformation temperature equal to or higher than room temperature.

### BRIEF DESCRIPTION OF DRAWINGS

[FIGS. 1A and 1B] FIGS. 1A and 1B are photographs each showing the operation of an actuator of Example 1, wherein FIG 1A shows the state at room temperature, and FIG. 1B shows the deformation state due to heating;
[FIGS. 2A to 2D] FIGS. 2A to 2D are photographs each showing the processing and operation of an actuator of Example 2, wherein FIG 2A shows the non-processed state, FIG 2B shows the state during processing, FIG. 2C shows the state at ordinary temperatures, and FIG 2D shows the state during heating;
[FIGS. 3A and 3B] FIGS. 3A and 3B are photographs each showing the operation of an actuator of Example 3, wherein FIG. 3A shows the state at room temperature, and FIG. 3B shows the deformation state due to heating;
[FIG 4] FIG 4 is an X-ray analysis pattern (room temperature) of a Ti₄₉Ni₂₈Cu₂₃ alloy thin film deposited by heating a glass substrate to 270°C;
[FIGS. 5A to 5D] FIGS. 5A to 5D are each a schematic view showing the principle of the actuator of Example 2;
[FIG. 6] FIG 6 is a perspective view showing a processed example of the actuator of Example 3;
[FIG. 7] FIG. 7 is a perspective view showing another processed example of the actuator of Example 3; and
[FIG 8] FIG 8 is a graph showing the relationship between the martensitic transformation peak temperature and the Cu content of the Ti-Ni-Cu crystal thin film manufactured on a glass substrate heated to 270°C.

### BEST MODE FOR CARRYING OUT THE INVENTION

### [Example 1]

This example is an example of an actuator using a residual stress generated during deposition.

In order to effectively use the residual stress accumulated in the thin film, it is necessary to release the binding of the substrate. To that end, the substrate is completely removed by etching or the like. The bidirectional shape memory alloy thin film thus obtained does not require a bias force, which enables easy manufacturing of an actuator.

The substrate herein referred to denotes a thick substrate (generally having a thickness of 100 µm or more) used as the foundation for deposition. Incidentally, a thin film interposed as an insulation layer or a diffusion barrier layer between the thin film and the substrate may be formed, if required, during deposition. However, this film is not required to be removed so long as it does not affect the mechanical characteristics of the shape memory alloy thin film.

The actuator of this example was manufactured in the following manner.

In a multiple magnetron sputtering device, a glass substrate (thickness 1.3 mm) was heated to 270°C to manufacture a 5 µm-thick 52at%Ti-33at%Ni-15at%Cu thin film. After deposition, the thin film was peeled from the glass substrate.

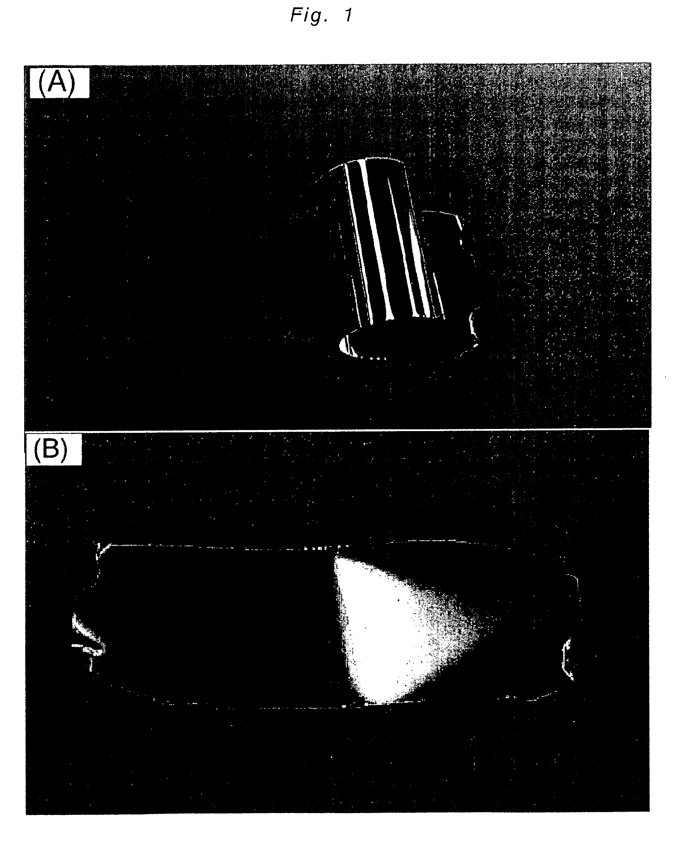

The following was confirmed: with a crystalline thin film, a residual stress remains during deposition; thus, by removing the binding from the substrate, it is possible to manufacture a bidirectional shape memory alloy thin film actuator having a residual stress as a bias force. The photographs of FIGS. 1A and 1B show the shape at room temperature and the shape upon heating to 100°C of the thin film single body. It has been confirmed that these shapes reversibly change by cooling / heating, and can be used alone as an actuator.

### [Example 2]

This example is an example in which a plastically deformable substrate is used in order to control the bidirectional shape changes of the shape memory alloy thin film with more precision.

Herein, as the plastically deformable substrate, any material is acceptable so long as it can be applied with permanent deformation by deformation (e.g., deformation up to about 5 % for a Ti-Ni-Cu thin film) in the variant rearrangement region at a temperature at which the shape memory alloy thin film is in a low temperature phase. A metal such as Al, Cu, or W, or an alloy or a resin such as polyimide is applicable.

The actuator of this example was manufactured in the following manner.

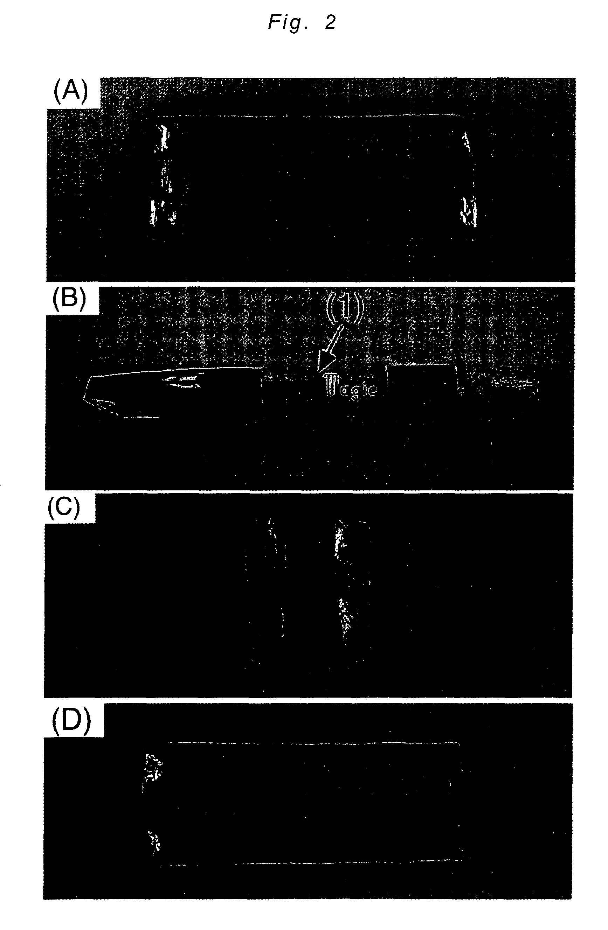

In a multiple magnetron sputtering device, on a 16 µm-thick Al foil for household use, heated to 310°C, a 8 µm-thick 49at%Ti-28at%Ni-23at%Cu thin film was deposited. Immediately after completion, the resulting film has an outward appearance as shown in FIG. 2A. In the non-processed state after deposition, the film is in a flat state along the basic shape of the base material.

Then, for forming into a cylindrical shape, the lamination is wound around a tubular shaft (1) with the thin film inside as shown in FIG 2B, thereby to be applied with plastic deformation. The shape to be herein given by plastic deformation is not limited to the cylindrical shape so long as it has a deformation amount capable of variant rearrangement. A more complicated three dimensional shape is also acceptable. The state in which the tubular shaft (1) has been extracted with plastic deformation thus applied thereto is shown in FIG. 2C.

FIG. 2C shows the shape close to the shape wound around the tubular shaft (1) (which returns in the elastic deformation amount of the deformation). This indicates that the base material has been plastically deformed into a desirable shape.

The following was confirmed. Upon heating to 100°C, as shown in FIG. 2D, the shape returns to the shape in a non-processed state after deposition, and returns to the initial processed shape (FIG. 2C) as the temperature approaches room temperature.

The principle in which such a bidirectional actuator can be obtained will be described below (seeFIGS. 5A to 5D).

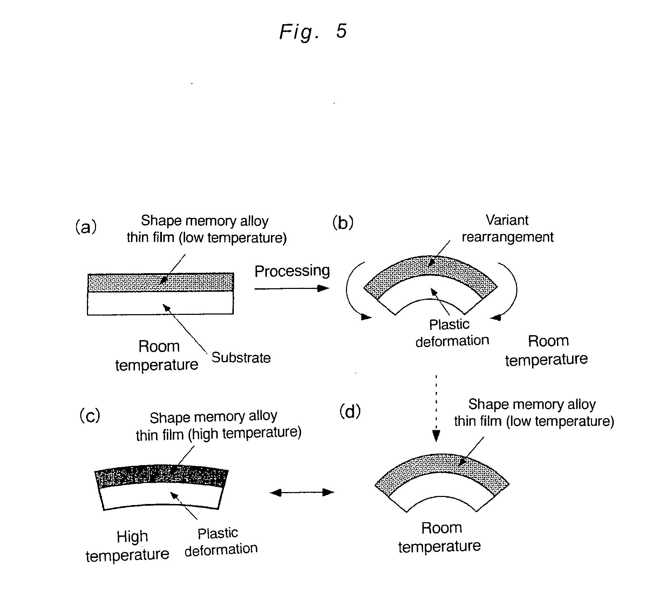

FIG. 5A shows the non-processed state after deposition, where the thin film is in a low temperature phase state. However, it is important to apply the substrate with plastic deformation as shown in FIG. 5B in this state. The thin film only changes in shape by variant rearrangement of the low temperature phase. Therefore, upon heating, the thin film remembers the original shape, and the substrate undergoes elastic deformation, and changes into the shape close to the original shape (FIG. 5C). Then, upon cooling, the thin film comes in the low temperature phase, and becomes soft, and hence returns to the shape (FIG. 5D) of the substrate deformed by processing.

A substrate capable of being applied with plastic deformation at room temperature is preferable. However, apparent from the principle, heating or cooling may be carried out so long as the temperature is within the temperature range in which the thin film is in the low temperature phase. Further, when a plastically deformable material is used for a part of the substrate, a bias force can be applied. Thus, it does not matter if the substrate is a composite material of two or more layers.

### [Example 3]

This example is an example of a bidirectional shape memory alloy thin film actuator obtained by performing low-temperature deposition on a resin or metal thin film capable of undergoing deformation processing.

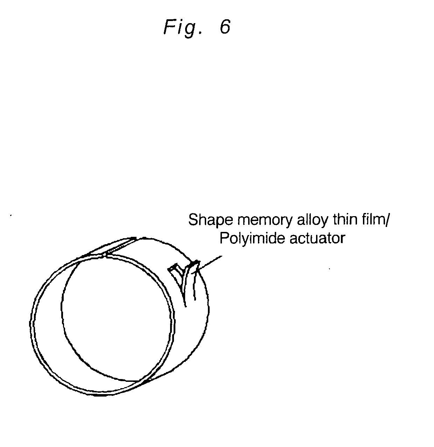

As the method for applying bidirectional shape changes, there is known the one using a thermal stress from a Si substrate. However, the substrate cannot be used in a deformed form. Thus, only a device including a shape memory alloy thin film actuator disposed on a plane (two dimensionally) can be manufactured. In this example, low temperature deposition is performed on a deformation processable resin or metal thin film in place of the Si substrate. This enables manufacturing of a bidirectional shape memory alloy thin film actuator also capable of three-dimensional disposition as shown in FIG. 6.

As the deformable substrate, a synthetic resin film such as a polyimide film, or foil of Al, CI, W, or the like with a thickness of 1 mm or less is preferable.

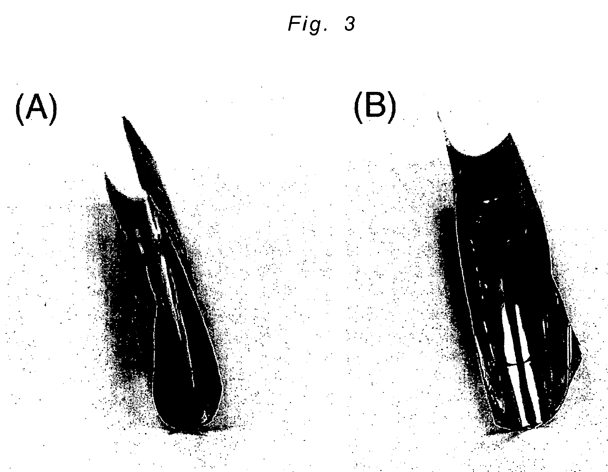

The actuator of this example was manufactured in the following manner. In a multiple magnetron sputtering device, a 25 µm-thick polyimide film was heated to 310°C, and a thin film of a 8 µm-thick 49at%Ti-28at%Ni-23at%Cu was deposited. The composite body including the polyimide substrate and the thin film thus manufactured shows the reversible shape changes as shown in FIGS. 3A and 3B by heating / cooling. When this composite body is processed and formed, the partial actuator as shown in FIG. 6 can be manufactured. The actuator does not use the whole shape memory alloy thin film for the actuator, but uses the most part thereof as a holding part (the annular portion), and a part thereof as the actuator. In this case, it does not matter if the thin film not used as the actuator is removed by patterning or the like.

With the one thus using a synthetic resin film or foil of Al, Cu, W, or the like as the base material, it is possible to obtain the actuator and the portion accompanying thereto integrally by using the formability of the base material.

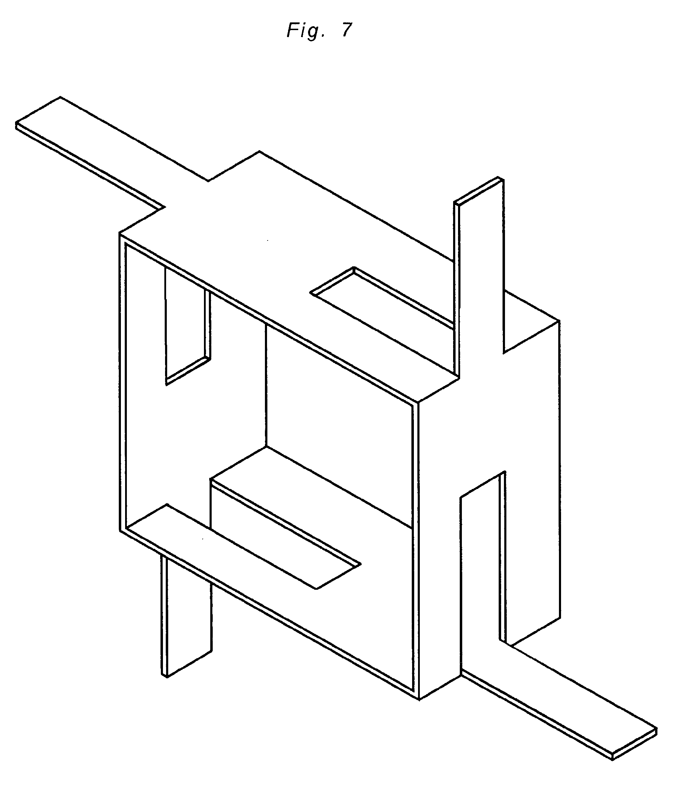

When a plurality of actuators are disposed at a prescribed interval, a previously formed deposited film is formed and processed, which can result in the one as shown in FIG 7.

With the partial actuator shown in FIG 7, the actuator protrudes in four directions as the corners of the angular tubular holding parts as the starting points.

### [Example 4]

This example is for describing the alloy composition applicable to any of Examples 1 to 3, and a deposition method thereof.

With a sputtering process, a substrate is heated to 270°C or more and less than the heat resistant temperature of the substrate to manufacture a crystalline shape memory alloy thin film.

When the substrate temperature is 270°C or less, the manufactured substrate is in an amorphous phase, and does not show a shape memory effect. On the other hand, when it is at the heat resistant temperature of the substrate, or higher, deformation of the substrate occurs. When the heat resistant temperature of the substrate exceeds 450°C, even heating to more than 450°C can result in a crystalline film. However, the reaction between the substrate and the thin film becomes a problem, so that a shape memory alloy thin film having favorable characteristics is difficult to obtain.

Out of the shape memory alloy thin films, the (Ni, Cu) side Ti-Ni-Cu alloy thin film can be obtained in the following manner. On a substrate heated to 270°C or more and less than the heat resistant temperature of the substrate, a Ti-Ni-Cu alloy thin film with a (Ni, Cu)-rich side composition having contents on an atom basis of Ti: more than 1/3 and less than 1/2 of the total amount, Cu: 6 to 26 % of the total amount, and the balance being Ni is deposited.

The Ti content is limited as the two-phase coexistence region of the TiNiCu phase and the B2 phase. Namely, when the TiNiCu phase does not exist, a sufficient generating force cannot be obtained. Whereas, without the B2 phase aiming at the shape memory effect, the function as the actuator cannot be obtained.

When the Cu content is less than 6 %, the transformation temperature is room temperature or lower, so that a practical actuator cannot be obtained. Whereas, when the Cu content exceeds 26 %, the actuator becomes brittle, and the transformation temperature also decreases to room temperature or lower. Therefore, the Cu content is required to be 6 to 26 % of the total amount.

On the other hand, out of the shape memory alloy thin films, the Ti-rich side Ti-Ni-Cu alloy thin film can be obtained in the following manner. On a substrate heated to 270°C or more and less than the heat resistant temperature of the substrate, a Ti-Ni-Cu alloy thin film with a Ti-rich side composition having contents on an atom basis of Ti: more than 1/2 and less than 2/3 of the total amount, Cu: 14 to 19 % of the total amount, and the balance being Ni is deposited.

The Ti content is limited as the two-phase coexistence region of the Ti₂(Ni, Cu) phase and the B2 phase.

Namely, when the Ti₂(Ni, Cu) phase does not exist, a sufficient generating force cannot be obtained. Whereas, without the B2 phase aiming at the shape memory effect, the function as the actuator cannot be obtained.

When the Cu content is less than 14 %, a crystalline film cannot be obtained, or the transformation temperature is room temperature or lower, so that a practical actuator cannot be obtained. Whereas, when the Cu content exceeds 19 %, the actuator becomes brittle, and the transformation temperature also decreases to room temperature or lower. Therefore, the Cu content is required to be 14 to 19 % of the total amount. When the substrate has been heated to 270°C or more and less than the heat resistant temperature of the substrate, various deposition processes can be used. However, a sputtering process whereby the composition control is easy is preferable. Particularly, the (Ni, Cu)-rich side Ti-Ni-Cu alloy thin film can also be manufactured by multiple sputtering using three kinds of pure metals of Ti, Ni, and Cu. However, it can be manufactured using a castable Ti₅₀Ni₍₅₀₋ₓ₎Cuₓ alloy target by utilizing the fact that the sputtering yields of Ni and Cu are larger than the yield of Ti.

In actuality, using a multiple magnetron sputtering device, each thin film of 55at%Ti-45at%Ni, 52at%Ti-25at%Ni-23at%Cu, 52at%Ti-33at%Ni-15at%Cu, and 49at%Ti-28at%Ni-23at%Cu was deposited on a glass substrate heated to 210°C to 340°C. Table 1 shows the results of examination of the crystallinity of each manufactured thin film.

It is shown that a crystalline film can be obtained at 340°C or higher with the 55at%Ti-45at%Ni thin film, and at 270°C or higher with other thin films. The substrate temperature shown in Table 1 is the temperature of the substrate surface (deposited film surface) measured by means of a non-contact thermometer.

**[Table 1]**

| **Substrate temperature** | **Thin film composition** | | | |
|---|---|---|---|---|
| | **(A)** | **(B)** | **(C)** | **(D)** |
| **340°C** | **Crystalline film** | **Crystalline film** | - | - |
| **270°C** | **Amorphous** | **Crystalline film** | **Crystalline film** | **Crystalline film** |
| **210°C** | **Amorphous** | **Amorphous** | **Amorphous** | **Amorphous** |
| **(A) Ti₅₅Ni₄₅** | | | | |
| **(B) Ti₅₂Ni₃₃Cu₁₅** | | | | |
| **(C) Ti₅₂Ni₂₅Cu₂₃** | | | | |
| **(D) Ti₄₉Ni₂₈Cu₂₃** | | | | |

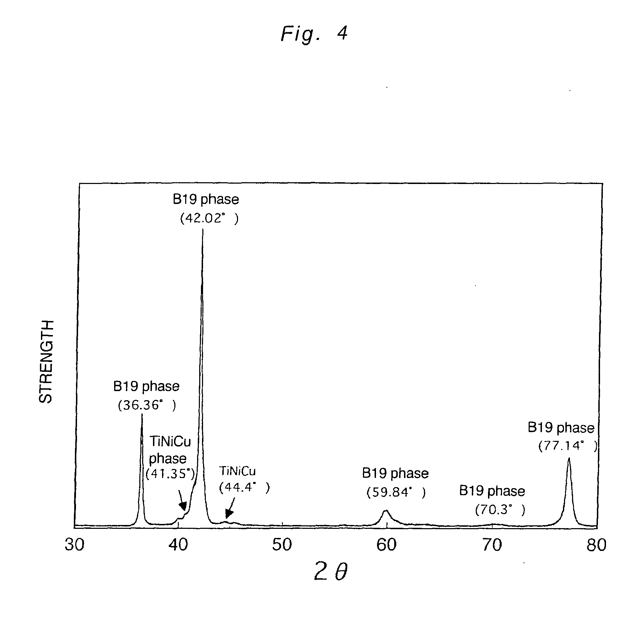

FIG 4 shows an X-ray diffraction pattern at room temperature of the 49at%Ti-28at%Ni-23at%Cu thin film manufactured by heating the glass substrate to 270°C. It is shown that all the peaks in FIG 4 except for the peaks of the TiNiCu phase are the diffraction peaks of the B19 phase. The B19 phase is the low temperature phase (martensite phase) of the Ti-Ni-Cu type alloy thin film. This indicates that the thin film is a crystalline thin film, and that the martensitic transformation temperature is above room temperature.

Further, thin films (all with a thickness of 5 to 8 µm) of 52at%Ti-25at%Ni-23at%Cu, 52at%Ti-28at%Ni-20at%Cu, 52at%Ti-33at%Ni-15at%Cu, and 49at%Ti-28at%Ni-23at%Cu were deposited on Al foil for household use (thickness 16 µm), polyimide (thickness 25 µm), and glass substrates heated to 310°C. However, the thicknesses of the thin films and the substrates are not limited to these thicknesses. Any thickness is acceptable so long as it can be applied to a thin film with a thickness of 30 µm or less obtained with a general sputtering process, and further, the thickness of the substrate may also be a deformable thickness, for example, 1 mm or less.

By means of a multiple magnetron sputtering device, thin films of 52at%Ti-38at%Ni-10at%Cu, 52at%Ti-35at%Ni-13at%Cu, 52at%-33at%Ni-15at%Cu, 52at%Ti-28at%Ni-20at%Cu, 51at%Ti-26at%Ni-23at%Cu, 49at%Ti-46at%Ni-5at%Cu, 49at%Ti-43at%Ni-8at%Cu, 49at%Ti-41at%Ni-10at%Cu, 49at%Ti-38at%Ni-13at%Cu, 49at%Ti-36at%Ni-15at%Cu, 49at%Ni-28at%Ni-23at%Cu, and 49at%Ti-25at%Ni-26at%Cu were deposited on glass substrates heated to 270°C.

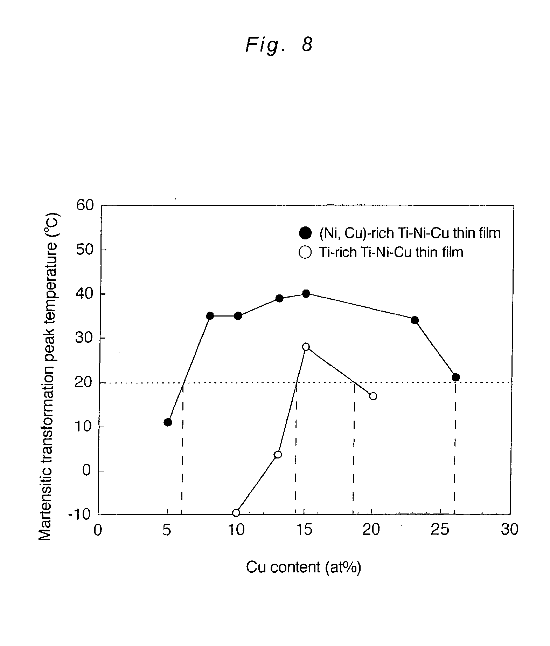

Table 2 shows the martensitic transformation peak temperature of each thin film measured by means of a differential thermal analysis device. FIG 8 is a graph arranging the martensitic transformation peak temperature by the Cu content. In order to obtain the transformation temperature equal to or higher than room temperature, the Cu content is required to be controlled. Even when the Cu content is either low or high, the transformation temperature equal to or higher than room temperature cannot be obtained. The optimum composition range of the Cu content varies between the Ti-rich side Ti-Ni-Cu alloy thin film and the (Ni, Cu)-rich side alloy thin film. It is 14 to 19 % for the Ti-rich side thin film, and becomes as wide as 6 to 26 % for the (Ni, Cu)-rich side alloy thin film. In this composition range, the transformation temperature tends to be roughly constant. Further, for the Ti-rich side alloy thin film, when the Cu content exceeds 20 %, the film becomes brittle. In contrast, for the (Ni, Cu)-hch side thin film, even when the Cu content exceeds 20 %, the film is less likely to be broken. Thus, the film is evaluated as more practical as compared with the Ti-rich side alloy.

**[Table 2]**

| **Composition of thin film** | **Martensitic transformation peak temperature (°C)** |
|---|---|
| **Ti₅₂Ni₃₈Cu₁₀** | **-10** |
| **Ti₅₂Ni₃₅Cu₁₃** | **4** |
| **Ti₅₂Ni₃₃Cu₁₅** | **28** |
| **Ti₅₂Ni₂₈Cu₂₀** | **17** |
| **Ti₅₁Ni₂₆CU₂₃** | **Brittle and unmeasurable** |
| **Ti₄₉Ni₄₆Cu₅** | **11** |
| **Ti₄₉Ni₄₃Cu₈** | **35** |
| **Ti₄₉Ni₄₁Cu₁₀** | **35** |
| **Ti₄₉Ni₃₈Cu₁₃** | **39** |
| **Ti₄₉Ni₃₆Cu₁₅** | **40** |
| **Ti₄₉Ni₂₈CU₂₃** | **34** |
| **Ti₄₉Ni₂₅Cu₂₆** | **21** |

### INDUSTRIAL APPLICABILITY

The bidirectional shape memory alloy actuator of the present invention can be manufactured at low temperatures. Further, the disposition of the actuator is not required to be limited to a plane. Thus, the actuator can be used as an actuator for moving various components.

The one not requiring a substrate is small in heat capacity, and can be expected to implement high-speed driving. For example, application to a micropump or a micromirror, or a flap for control of the flow rate of a gas or a liquid is conceivable.

Further, for the one set in a prescribed shape by plastically deforming the substrate, the following and other applications are conceivable. It is changed into a desirable shape at room temperature, and then, is made straight by heating. Thus, it is allowed to pass through a narrowed part, and then, is returned to the complicated shape at room temperature again for use.

Further, by deposition on a heat-resistant adhesive tape made of Al, it can be used as a handy type actuator to be bonded to a curved part or the like for use. For example, by use for a three-dimensional microrobot freely moving in the space, or the curved part, the usage as in the artificial muscle is also conceivably possible. Further, when deposited on a diaphragm of a pump, or the like, it can also be used as a simple driving mechanism.

## Claims

1. A bidirectional shape memory alloy thin film actuator comprising a crystalline shape memory alloy thin film, **characterized by** being substantially formed in a single layer while still having a residual stress during deposition.

2. A method for manufacturing the bidirectional shape memory alloy thin film actuator according to claim 1, **characterized by**: depositing a crystalline shape memory alloy thin film on a substrate while heating the substrate to less than the heat resistant temperature, and then, removing the substrate from the thin film, resulting in a single layer.

3. A bidirectional shape memory alloy thin film actuator comprising a substrate and a shape memory alloy thin film integral therewith, **characterized in that** the substrate is plastically deformable in a variant rearrangement deformation region of the thin film, and the substrate is plastically deformed, and is set in an initial shape.

4. A bidirectional shape memory alloy thin film actuator comprising a substrate and a shape memory alloy thin film integral therewith, and showing a transformation temperature equal to or higher than room temperature, **characterized in that** the substrate is bendable metal foil or resin film.

5. The bidirectional shape memory alloy thin film actuator according to claim 1, 3, or 4, **characterized in that** the thin film is a Ti-Ni-Cu shape memory alloy thin film.

6. A method for manufacturing a shape memory alloy thin film for use in the bidirectional shape memory alloy thin film actuator according to claim 5, **characterized by** depositing Ti, Ni, and Cu on a substrate while heating the substrate to 270°C or more and less than the heat resistant temperature thereof, and forming a Ti-Ni-Cu alloy thin film.

7. The method for manufacturing a shape memory alloy thin film according to claim 6, **characterized in that** Ti, Ni, and Cu are deposited such that the contents on an atom basis of respective atoms of the deposited Ti-Ni-Cu alloy thin film are Ti: more than 1/2 and less than 2/3 of the total amount, Cu: 14 to 19 % of the total amount, and the balance being Ni.

8. The method for manufacturing a shape memory alloy thin film according to claim 6, **characterized in that** Ti, Ni, and Cu are deposited such that the contents on an atom basis of respective atoms of the deposited Ti-Ni-Cu alloy thin film are Ti: more than 1/3 and less than 1/2 of the total amount, Cu: 6 to 26 % of the total amount, and the balance being Ni.
